Europäisches Patentamt

(19) European Patent Office

Office européen des brevets

(11) Publication number: **0 036 320**
**B1**

(12) **EUROPEAN PATENT SPECIFICATION**

(45) Date of publication of patent specification: **20.06.84**

(51) Int. Cl.³: **C 08 J 5/18**

(21) Application number: **81301087.3**

(22) Date of filing: **16.03.81**

(54) Film of aromatic polyamide and process therefor.

(30) Priority: **17.03.80 US 130851**

(43) Date of publication of application:
**23.09.81 Bulletin 81/38**

(45) Publication of the grant of the patent:
**20.06.84 Bulletin 84/25**

(84) Designated Contracting States:
**BE DE FR GB IT NL**

(56) References cited:
**US - A - 3 819 587**
**US - A - 4 070 433**

**CHEMICAL ABSTRACTS, vol. 84, no. 2, 12th
January 1976, page 27, no. 5750p Columbus,
Ohio, U.S.A. I.S. BELYAEV et al.: "Thermal aging
of aromatic polyamides"**

(73) Proprietor: **E.I. DU PONT DE NEMOURS AND
COMPANY**
**Legal Department 1007 Market Street
Wilmington Delaware 19898 (US)**

(72) Inventor: **Garlington, William Drake**
**209 Lister Drive Hyde Park
Wilmington Delaware 19808 (US)**
Inventor: **Swerlick, Isadore**
**4616 Sylvanus Drive
Wilmington Delaware 19803 (US)**

(74) Representative: **Jones, Alan John et al,
CARPMAELS & RANSFORD 43 Bloomsbury
Square
London, WC1A 2RA (GB)**

Courier Press, Leamington Spa, England.

## Description

### Background of invention

This invention concerns improvements in and relating to film of aromatic polyamides such as poly-meta-phenylene isophthalamide, and to a process for making the improved film.

Film of an aromatic polyamide is known in the art, such as disclosed in U.S. Patents 3,287,324 and 4,070,433, and is desirable for various uses in view of its low flammability. However, as initially prepared, noncrystalline and undrawn film is unsuitable for some uses because of generally inadequate values of certain physical properties indicative of toughness, such as its physical strength as evidenced, for example, by pneumatic impact strength and by resistance to breakage in a wire bend test to be described below. Although crystalline film retains good tenacity and elongation at high temperature, it tends to be brittle. Drawn film tends to have better physical strength, but is expensive to make because of the cost of the apparatus and process used for drawing.

It is therefore an object of this invention to provide film of aromatic polyamide which is noncrystalline and undrawn, and yet has toughness.

It is a further object to provide a process for making such film.

### Summary of the invention

Film of aromatic polyamide which is noncrystalline and undrawn and which has a pneumatic impact strength of 2 kg-cm/0.254 mm (1 mil) and greater has now been made.

More specifically, according to the invention there is now provided a film of a wholly aromatic polyamide at least 85% of the repeating units of which are metaphenylene isophthalamide units, said polyamide having an inherent viscosity of at least 1.2 deciliters/g in concentrated sulfuric acid at 30°C at a concentration of 0.5 gram of polymer per 100 cm³ of solution and being soluble to the extent of 1 g of polyamide in a solvent consisting of 9 g of N,N-dimethylacetamide and 1 g of $CaCl_2 \cdot 2H_2O$ at 25°C, said film being transparent, undrawn, and non-crystalline and having a pneumatic impact strength of at least 2 kg-cm/0.0254 mm (1 mil).

There is also provided according to the invention a method for treating an undrawn, noncrystalline film of a wholly aromatic polyamide, at least 85% of the repeating units of which are meta-phenylene isophthalamide units, to increase its pneumatic impact strength to at least 2 kg-cm/0.0254 mm (1 mil) said polyamide having an inherent viscosity of at least 1.2 deciliters/g in concentrated sulfuric acid at 30°C at a concentration of 0.5 gram of polymer per 100 cm³ of solution, said method comprising heating the film to a temperature in the range of 400 to 300°C for a period of time ranging from about 2 seconds to 2 minutes, while maintaining the film at constant length and width or permitting the film to shrink by at most 20% in each of the length and width.

### Detailed description of the invention

By wholly aromatic polyamide is meant a polyamide derived from a diamine in which each amino group is directly attached to a carbon atom of an aromatic ring, and a dicarboxylic compound in which each carboxyl group is directly attached to a carbon atom of an aromatic ring; in the case of polycyclic aromatic compounds wherein two aromatic moieties are joined by an aliphatic hydrocarbon moiety, both aromatic moieties should be attached to the same carbon atom of the aliphatic hydrocarbon moiety. The wholly aromatic polyamides employed in the present invention are derived from diamines such as meta-phenylenediamine, para-phenylenediamine, 4,4'-diaminodiphenyl ether, 4,4'-diaminodiphenylmethane, 4,4'-diaminodiphenyl sulfone, benzidine, etc., and diacyl halides of dicarboxylic acids such as isophthalic acid, terephthalic acid, 4,4'-bibenzoic acid, 2,2-bis(4-carboxyphenyl)propane, benzophenone-4,4-dicarboxylic acid, etc. The polyamide contains at least 85% meta-phenylene isophthalamide repeating units, and is preferably at least 95% such repeating units.

As the terms are employed herein, isophthalic acid, isophthaloyl chloride, meta-phenylene isophthalamide units, and poly-meta-phenylene isophthalamide all refer to and include materials and compositions based not only on pure isophthalic acid or isophthaloyl chloride, but also on commercial grades of isophthalic acid or isophthaloyl chloride, which include variable amounts, e.g., often up to about 5% by weight, of other isomers. Also, meta-phenylenediamine refers not only to the pure diamine, but also to commercial grades which contain variable amounts, e.g. up to about 5% by weight, of other isomers. The same may be true of any of the diacyl halides and diamines from which the polyamides are made.

So as to be of high enough molecular weight to attain a pneumatic impact strength of at least 2 kg-cm/0.0254 mm (1 mil) in the process of the invention, the polyamide used must have an inherent viscosity of 1.2 deciliter/g, preferably 1.3 deciliters/g, measured in concentrated sulfuric acid at 30°C at a concentration of 0.5 g of polymer per 100 cm³ of solution.

The wholly aromatic polyamides employed in the present invention have low solubility in most of the common organic solvents. For the process of this invention, they are dissolved in a liquid selected from the group consisting of N,N-dimethylacetamide (DMAC), N,N-dimethylformamide (DMF), N-methyl-2-pyrrolidone, and dimethylsulfoxide, and they are conveniently made in such a liquid by either batch or continuous processes, from the aromatic acid in the form of its diacid halide, e.g., the diacid chloride or bromide, and the aromatic diamine. The hydrogen halide liberated in formation of the polyamide can be neutralized by addition of a suitable hydroxide or oxide, so as to provide a salt from the class consisting of calcium bromide, sodium bromide, ammonium bromide, lithium bromide, lithium chloride, calcium chloride, and magnesium chloride. The hydroxide or oxide is chosen to form one of said salts. The salt and a liquid from the above-mentioned group are chosen so that they form a solution which has a specific resistance of less than 5000 ohm-centimeters as measured on a solution of 1/100 of an equivalent of the salt in one liter of the liquid at 20°C. A salt concentration of 0.2 to 15% by weight of salt to liquid is employed in the practice of this invention. Higher or lower amounts of salt, however, may be used depending upon the particular polymer and solvent employed. The liquid chosen should be one in which the polyamide dissolves to the extent of at least 0.5% by weight at 20°C. Water in an amount of up to 7% by weight, preferably 1 to 4% by weight of liquid, salt, polyamide and water may be present, arising from water formed in neutralization of hydrogen halide with the hydroxide or oxide and from water in the liquid component used. The polyamides have enhanced solubilities in such liquid/salt media, and solutions of 3 to 30% by weight of the polyamide can be prepared in such liquid/salt media, based on the weight of said liquid. When such solutions are prepared by dissolving a preformed polyamide in such a liquid/salt medium, it is sometimes necessary to heat the mixture, but the polymer will remain in solution on cooling it to room temperature, and heating is preferred to increase the rate of dissolution. Further information about such solutions of polyamides in these liquid/salt media can be found in U.S. Patent 3,068,188.

The heat treated film of the invention remains soluble in such liquid/salt media, e.g. to the extent of 1 g of polyamide in a solvent consisting of 9 g of N,N-dimethylacetamide and 1 g of $CaCl_2 \cdot 2H_2O$ at 25°C. Solubility in this solvent is indicative that the polyamide is not crosslinked. Heating of the polyamide for longer times and at higher temperatures than those specified herein can lead to crosslinking of the polymer.

Such solutions can be cast into film form on a support. The support can be fabricated of metal such as stainless steel or of a plastic such as polyethylene, polytetrafluoroethylene, or a polyester, e.g., polyethylene terephthalate. In a continuous process, the support can be in the form of an endless belt or a drum. The solution is cast onto the belt in a thickness which is readily calculated from the thickness of the desired dry film and the amount of polymer in the solution. Final film thicknesses of about 2.5 to about 125 micrometers (0.1 to 5 mils), preferably about 6 to about 50 micrometers (0.25 to 2 mils), can be made.

With the film still carried on the support, part of the liquid component of the solvent is removed from the film by vaporizing it with heat at a temperature no greater than 5°C below the boiling point of the solution. Liquid is removed in this manner until the amount of liquid remaining in the film is in the range of 50 to 160% by weight based on the amount of polyamide. Thinner films are usually dried to a solvent content in the lower end of this range, while thicker films are dried to a solvent content in the middle or upper part of the range. The heat can suitably be supplied by a heated gas such as air or nitrogen, by conduction from a heated surface (e.g., a coating drum or belt), or by radiant heaters. The time required to dry to the indicated solvent content varies with factors such as the temperature of the gas or heaters used, the thickness of the cast film, and the composition of the solution used, and is easily determined by one of ordinary skill. In the case of removing DMAC from a 0.0254 mm (1 mil film) (dry thickness), temperatures of about 80—100°C for 3 to 5 minutes are suitable. As explained below, the film can be removed from the support during or just after this liquid-removal step.

The film is next washed with a fluid comprising a major proportion of liquid water until the amount of residual liquid component of the solvent for the polyamide is reduced to less than 3% by weight, preferably less than 2% by weight, most preferably less than 1% by weight, based on the polyamide, and the amount of residual salt component of the solvent for the polyamide is reduced to less than 0.3% by weight, preferably less than 0.2% by weight, most preferably less than 0.1% by weight, based on the polyamide. The time required for this step varies with factors such as the thickness of the film, the amount of liquid and salt components of the solvent to be removed, and the temperature of the wash water, and is easily determined by one of ordinary skill. In a continuous process, a series of tanks of wash water can be used, and one suitable arrangement is to employ a countercurrent flow of wash water from the last tank progressively toward the first tank. Flooding of each tank separately with fresh water is another suitable arrangement. The wash water can be of any temperature convenient or desired, e.g., from about 1°C to about 95°C; temperatures of about 5° to 35°C are convenient and suitable. The initial wash water into which the film is placed for the first 5 seconds to 1 minute should be below about 20°C, the longer times being needed for thicker films and the shorter times being satisfactory for thinner films. For films 12 to 50 micrometers thick (dry thickness), washing times of about 1 to 20 minutes are typical. At this point, the amount of water in the film is 50 to about 150% by weight based on the weight of the dry film.

Next, wash water which remains in the film is removed from the film by vaporizing it with the aid of heat below a temperature of 150°C until the amount of water in the film is less than 15% by weight, preferably less than 8% by weight, based on the polyamide. During this drying step, the film should be maintained at constant length and width or should be permitted to shrink by at most 20% in each of the length and width. Preferably, the film is maintained at constant length (machine direction) and is permitted to shrink by at most 20% in width (transverse direction). Most preferably the film is maintained at constant length and width. In cases where the film remains adherent to the support through part of this drying step, the film is thereby restrained from shrinking in either length or width. After the film has been separated from the support, constant length and width can suitably be maintained, e.g., by use of a pin-type tenter frame, or by keeping the film during drying in contact with the rolls of a roll dryer under tension so that at most only minimal shrinkage occurs. In a roll dryer, shrinkage of up to about 6% can occur in the transverse direction, and by running some of the rolls, e.g., the last rolls, at a slightly reduced speed shrinkage of up to about 2% can occur in the machine direction. The heat required can be supplied in various ways, e.g., rolls heated internally as by steam, hot oil or electrical resistance heaters; heated gas such as air or nitrogen; or radiant heaters. The time required for this drying step varies with factors such as the temperature of the gas or heaters used, the thickness of the film, and the amount of water in the film, and is easily determined by one of ordinary skill. Typically, temperatures ranging from about 60° to about 125°C for times of 0.5 to 5 minutes are suitable.

The film can be stripped from the support on which it was cast during the water-drying step just described, during the water-washing step which precedes that step, or during the liquid-removal step which precedes washing with water, or at the transitions between these steps. It is preferred to remove the film from the support no later than during the water-washing step so as to increase the efficiency of removal of salt and organic liquid from the film during washing with water.

In accord with the invention, the film is then subjected to a heat treatment step wherein the film is heated to a temperature in the range of 400 to 300°C for a period of time ranging from 2 seconds to 2 minutes. Preferably the film is heated to a temperature of 375 to 325°C for a time from 2 to 30 seconds. The higher temperatures in the indicated ranges will be used for the shorter times indicated, and conversely, the lower temperatures will be used for the longer times. The heat can be supplied, e.g., by radiant heaters, or by a hot gas. The heat treatment can be carried out in any suitable atmosphere, such as air or nitrogen.

During this heat treatment step, the film is maintained at constant length and width, or is permitted to shrink by at most 20% in each of the length and width. Preferably the film is maintained at constant length (machine direction) and is permitted to shrink by at most 20% in width (transverse direction). It is further preferred to restrain the film at least partially in both the length and width, as good sheet flatness, i.e., a non-puckered film, is thereby obtained. Most preferably the film is maintained at constant length and width, which can suitably be accomplished, e.g., by use of a pin-type tenter frame.

Film so made is noncrystalline as determined by X-ray diffraction and is undrawn, i.e., has not been extended to longer dimension in either length or width. It has improved physical strength when compared with film not heat treated, as evidenced by a higher pneumatic impact strength. In accordance with the invention, film having a pneumatic impact strength of at least 2 kg-cm/0.0254 mm (1 mil), preferably at least 4 kg-cm/0.0254 mm (1 mil), can be prepared. The film is also colorless and transparent, and is thermally stable and flame resistant.

Film of poly-meta-phenylene isophthalamide so made has a density of at least 1.32 $g/cm^3$ at 25°C, and most often at least 1.33 $g/cm^3$ at 25°C. Such densities are indicative of at most only a low level of voids in the film. Voids of a size not visible upon inspection by eye, but present as indicated by low angle X-ray analysis, are ordinarily present in the film before the heat treatment of the invention, and are largely removed by coalescence during the heat treatment step.

Most films heat-treated in accordance with the invention also pass the wire bend test (described below) and thus have improved integrity when used for wire insulation, whereas both noncrystalline, undrawn film before heat treatment and crystalline film uniformly fail the wire bend test. Furthermore, film which has been heated too much, i.e., either at too high temperature or for too long a time or both, also fails the wire bend test, is insoluble in the 9:1 DMAC:$CaCl_2 \cdot 2H_2O$ solvent described above, and is apparently degraded as evidenced by the onset of a yellow color.

As determined by differential scanning calorimetry, film which has been heat-treated as described herein has a glass transition temperature (second order transition temperature) about 15°C higher than such film before heat treatment, and both the heat-treated and unheat-treated films exhibit an exotherm indicative of thermal crystallization and an endotherm indicative of crystalline melting. Both types of film, though noncrystalline by X-ray diffraction, thus have some short range order below a size detectable by X-ray diffraction, and are thermally crystallizable.

Test methods
Impact strengths given herein refer to the pneumatic ball impact test method of ASTM (American Society for Testing Materials) D3099.

In the wire bend test, a metal wire of diameter 1.024 mm (AWG wire gauge 18) is wound for 15—20 cm (6—8 inches) of its length with a strip of the film to be tested which is 9.5 mm (3/8 inch) wide, the film strip being tightly wound on the wire with an overlap of about 50% and a wrap angle of about 45°, the two ends of the film strip being secured with small pieces of a pressure sensitive tape (tape with a backing of cellulose acetate film or of cellulose, e.g. "masking tape", is suitable). A small

4

lathe can be used in wrapping the strip of film to be tested on a wire. The portion of wire insulated with film is then immersed for 30 seconds in a bath of molten solder (50:50 tin:lead) maintained at 300°C, removed from the bath, and permitted to cool and cleaned of any adherent solder. The insulated portion of wire is then bent back on itself so as to form 4 to 6 tight spiral loops around its own circumference, and the film insulation on the loops is examined for any breaks. The presence of one or more breaks in the film is rated as a failure, and no breaks in the film is a pass.

To further illustrate the innovative aspects of the present invention, the following examples are provided.

Example 1

A solution of poly-meta-phenylene isophthalamide (designated MPD-I), dimethylacetamide (DMAC), and calcium chloride, in the weight ratio 1:3.8:0.47 MPD-I:DMAC:CaCl$_2$, plus about 1.5 weight percent water at room temperature, was pumped through a 0.34 mm×27.9 cm wide (13.5 mil×11 inches wide) slot opening at about 38 ml/minute onto a 0.076 mm (3 mil) thick polyester film carrier travelling at 0.9 m (3 feet) per minute. It was then passed continuously into an arch air dryer with 3.66 m (12 foot) heated length, air jets on the top side, 88°C inlet air temperature. At the dryer's exit end, the concentrated solution, film, designated "gel film", and its carrier were interleafed with 0.0254 mm (1 mil) polyethylene film and wound up. The DMAC to polymer ratio in this gel film was approximately 1.6:1.

Subsequently, the polyethylene interleaf was stripped and the gel film on its carrier was unwound at the rate of 0.9 m (3.0 feet) per minute into a series of five room temperature water leach baths, with a total wet immersion of 7.3 m (24 feet). Each of the last four tanks were separately flooded with about 7.6 liters (2 gallons) per minute of room temperature deionized water; the first with 7.6 liters (2 gallons) per minute of cold tap water.

From the leach baths the wet film was transported at the same rate onto a 5-roll 20.3 cm (8-inch) diameter aluminum heated dryer. After about 270 degrees of contact on the first roll, the carrier film was stripped off and the wet MPD-I film continued through the dryer. Dryer roll surface temperatures were typically 100°, 85°, 105°, 125° and 125°C.

The dried MPD-I film was transported out of the dryer and wound up. Analyses indicated it contained typically 1.7% DMAC, 460 ppm calcium and 800 ppm chlorine. Tests showed it would shrink about 20% in either direction if heated to 280°C.

A piece of this film was restrained on a rectangular pin frame, with sharp pointed nails spaced every 19 mm (3/4 inch) around the periphery, and placed in a convective air oven for various temperatures and times. Results are shown in Table 1, and indicate that if such film is heat-treated under restraint at 340°C. for 10 to 30 seconds its properties were improved. Its shrinkage when reheated, unrestrained, to 280°C. for ten minutes was less than 2%. Surprisingly, its equilibrium moisture absorption was significantly reduced and it showed increased toughness in the wire bend test.

TABLE 1

| Temp. °C | Time sec. | Wire bend test | H$_2$O absorption % | Reheat Shrinkage 280° MD | TD |
|---|---|---|---|---|---|
| 340 | 30 | Passed | 4.03 | 1.3% | 0% |
| 340 | 20 | Passed | 3.72 | | |
| 340 | 10 | Passed | 3.28 | | |
| 200 | 120 | Failed | — | | |
| 200 | 190 | Failed | — | | |
| No heat | | Failed | 5.96 | ~20% | |
| Treatment | | Failed | 7.62 | ~20% | |

Other pieces of the dried MPD-I film were heat treated similarly while restrained on a pin frame, at 340°C and at 400°C in an oven for 60 seconds (actually slightly less than 60 seconds, as the pin frame and sample were removed from the oven after 30 seconds, rotated 180°, and quickly replaced in the oven for the remainder of the 60 seconds, to compensate for front-to-back nonuniformities in the oven). The impact strengths are given in Table 2.

TABLE 2

| | Heat treatment | | Pneumatic impact, kg-cm/0.0254 mm (1 mil) | | | |
|---|---|---|---|---|---|---|
| | Temp. °C | Time sec. | Avg. | Range | No. samples | Type failure |
| Sample | 340 | 60 | 10.6 | 1.8—21 | 6 | Stretch |
| | 400 | 60 | 1.7 | 1.6—1.9 | 3 | Stretch to brittle |
| Control | No treatment | | 0.92 | .70—1.0 | 5 | Brittle |

Another sample of film made in substantially the same way, and heat-treated in an oven at 360°C for 30 seconds was determined by X-ray diffraction to be non-crystalline.

Example 2

The procedure of Example 1 was substantially repeated to prepare films of nominal thickness 25 micrometers (1 mil), but with the following differences. The air temperature in the arch air dryer was 93°C. The DMAC to polymer ratio in the gel film was 1.28. Washing with deionized water at room temperature was in a series of four tanks with a total wet immersion of 11.6 m (38 ft), with the water flowing countercurrently from tank to tank at the rate of 7.6 liters (2 gallons) per minute. The line speed for water washing and the following drying step was 1.8 m/minute (6 ft/minute). A dryer with five rolls was used, with the polyester carrier film being stripped from the MPD-I film after the third roll; the surface temperatures of the rolls were 70°, 90°, 90°, 100° and 100°C. Samples of the film were heat treated at various temperatures for various times, with the conditions and results as shown in Table 3. All of these films were determined to be noncrystalline by X-ray diffraction.

TABLE 3

| Heat-treatment conditions | | Impact kg-cm/0.0254 mm (1 mil) | Inherent viscosity | Wire pass | Bend fail | Residual DMAC PPM | Density g/cm³ |
|---|---|---|---|---|---|---|---|
| Temp. °C | Time min. | | | | | | |
| CONTROL | | 0.45 | 1.29 | 0 | 3 | 6280 | 1.3026 |
| | | 0.90 | | | | | 1.3062 |
| 240 | 1 | .92 | | | | | |
| 260 | 1 | 1.10 | | | | | |
| 280 | 1 | 2.98 | | | | | |
| 300 | .5 | 4.47 | 1.35 | 3 | 0 | 3940 | 1.329 |
| | 1 | 4.63 | 1.35 | 3 | 0 | 2800 | 1.3358 |
| | 2 | 2.76 | 1.34 | 2 | 1 | 1330 | 1.3327 |
| 325 | .5 | 5.38 | 1.33 | 2 | 1 | 1520 | 1.3374 |
| | 1 | 5.86 | 1 36 | 3 | 0 | 900 | 1.3341 |
| | 2 | 5.55 | 1.34 | 3 | 0 | 300 | 1.3364 |
| 350 | .5 | 2.03 | 1.44 | 3 | 0 | 200 | 1.3364 |
| | 1 | 3.44 | — | 3 | 0 | 26.5 | 1.3347 |
| 375 | .5 | 3.47 | — | 0 | 3 | 4.7 | 1.3298 |
| 400 | .5 | 2.13 | — | 0 | 3 | 7.0 | 1.3375 |

Example 3

The procedure of Example 2 was substantially repeated to prepare films of nominal thickness 13 micrometers (0.5 mil), 25 micrometers (1 mil) and 51 micrometers (2 mils). The DMAC/polyamide ratio of the film just before water immersion is shown in Table 4. It was next leached in ice water for 1 hour, was separated from the support film, and was dried with restraint in an air oven at 120°C for 1 hour. Next the film was heat-treated at 325°C for 1 minute. The resulting properties of the heat-treated film, and the control unheat-treated film are also shown in Table 4.

### TABLE 4

| Nominal thickness of dry film | 0.0508 mm (2.0 mils) | 0.0254 mm (1.0 mil) | 0.0127 mm (0.5 mils) |
|---|---|---|---|
| DMAC/polyamide ratio | 1.46 | 1.28 | 1.05 |
| Pneumatic Impact, kg-cm/0.0254 mm (1 mil): | | | |
| Heat treated | 6.4 | 6.4 | 4.1 |
| Control, not heat-treated | 0.5 | 0.7 | 0.6 |
| Wire bend: pass/fail | | | |
| Heat-treated | 3/0 | 3/0 | 3/0 |
| Control | 1/2 | 0/3 | 0/3 |
| Density: g/cc | | | |
| Heat-treated | 1.3412 | 1.3418 | 1.3373 |
| Control | 1.3295 | 1.3377 | 1.3309 |

Example 4

The procedure of Example 3 was substantially repeated to prepare films 30 micrometers (1.2 mils) in thickness. Samples of the film were heat treated at various temperatures for 2 minutes, either while restrained on a frame or unrestrained. During heat treatment, the samples were covered on the side toward the high velocity stream of heated air with a glass cloth fabric, which retarded the rate of heating as compared to the rate when no such fabric is used. The results are given in Table 5.

### TABLE 5

| Heat treatment conditions Temp. °C | Pneumatic impact kg-cm/0.0254 mm (1 mil) Avg. | Lineal shrinkage % | Final film thickness mm (mils) |
|---|---|---|---|
| Unrestrained 300 | 5.3 | 19 | 0.0483 (1.9) |
| 325 | 5.7 | 22 | 0.0508 (2.0) |
| 350 | 7.3 | 25 | 0.0533 (2.1) |
| 375 | 6.0 | 25 | 0.0508 (2.0) |
| Restrained 300 | 3.6 | — | 0.0305 (1.2) |
| 325 | 4.1 | — | 0.0305 (1.2) |
| 350 | 5.4 | — | 0.0305 (1.2) |
| 375 | 3.5 | — | 0.0305 (1.2) |

Example 5

The procedure of Example 1 was substantially repeated through the water washing step. The film was then dried on a three roll dryer having chromium plated steel rolls of 20.3 cm (8-inch) diameter, the temperatures of the three rolls being 90°, 95° and 120°C. The film (approx. 25 cm, 10 in, wide) was mounted on a continuous pin-type tenter frame so as to be restrained to constant length and width, and was then heat treated under a panel of 105-volt radiant heaters 15 cm (6 in) long by 25 cm (10 in) wide, having a watt density of 3.1 watts/cm$^2$ (20 watts/in$^2$), the gap between the film and the heaters above the film being 1.9 cm (0.75 in) and the gap between the film and a reflective plate below the film being 1.9 cm (0.75 in). The film was transported past the radiant heater at a rate of 2.06 m/minute (6.75 ft/min), which provided a residence time under the heater of 4.44 seconds. As the average view factor at the center line of the film was 0.85, the effective residence time and the center line of the film was 3.77 seconds. The resulting heat treated film had a pneumatic impact strength of 2.10 kg-cm/0.0254 mm (1 mil), whereas the value for film not so heat treated was 1.06 kg-cm/0.0254 mm (1 mil). The heat treated film contained 100 ppm DMAC, and the permanent shrinkage (machine direction at the center line) after unrestrained reheating at 280°C for 10 minutes was 0.76%.

Comparative Example A

The procedure of Example 1 was substantially repeated through the water washing and drying steps. A sample of the film was then clipped to a metal frame and placed in glacial formic acid at 90°C for 30 minutes in order to crystallize it, this procedure having been shown with another sample of similar film to result in crystallinity as determined by X-ray diffraction. It was then washed in water for several minutes and dried at 100°C for 30 minutes. This film was 32.5 micrometers (1.28 mils) thick, had a pneumatic impact strength of 1.08 kg-cm/0.0254 mm (1 mil), and in three trials in the wire bend test had no passes and 3 failures.

Samples of the film were then heat treated in an oven at 325°C for 1 minute, and thus constitute crystalline polyamide film heat-treated under the conditions of the invention. This heat-treated film was 30.7 micrometers (1.21 mils) thick, had a pneumatic impact strength of 0.76 kg-cm/0.0254 mm (1 mil), and in three trials in the wire bend test had no passes and 3 failures.

Comparative Example B

The procedure of Example 1 was substantially repeated except that the heat treating was done

7

continuously under radiant heaters substantially as described in Example 5. A sample of the heat-treated film was crystallized by placing it in glacial formic acid at 90°C for 30 minutes, and then it was washed with water and dried at 100°C for 30 minutes, to provide yet another film which is both heat-treated and crystalline. This film was 32.2 micrometers (1.27 mils) thick, had a pneumatic impact strength of 1.11 kg-cm/0.0254 mm (1 mil), and in three trials in the wire bend test had no passes and 3 failures.

Industrial applicability

The technically advanced film of the invention is useful in various electrical applications, such as wire and cable insulation formed by spiral wrapping of film in the form of tape, and such as slot liners, insulation for transformers, in capacitors, and base and cover sheet for printed circuitry, and is especially good in such uses at high temperature. The film can also be used in automotive and aviation interior head lining materials and decorative trim, and in packaging materials. The method of the invention provides a way to prepare the improved tough film of the invention without resorting to the expense of making a drawn film.

**Claims**

1. A film of wholly aromatic polyamide, at least 85% of the repeating units of which are meta-phenylene isophthalamide units, said polyamide having a density of at least 1.32 $g/cm^3$, an inherent viscosity of at least 1.2 deciliters/g in concentrated sulfuric acid at 30°C at a concentration of 0.5 gram of polymer per 100 cc of solution and being soluble to the extent of 1 g of polyamide in a solvent consisting of 9 g of N,N-dimethylacetamide and 1 g of $CaCl_2 \cdot 2H_2O$ at 25°C, said film being transparent, undrawn, and noncrystalline and having a pneumatic impact strength of at least 2 kg-cm/0.0254 mm (1 mil).

2. The film of Claim 1 wherein the polyamide is poly-meta-phenylene isophthalamide.

3. The film of Claim 1 or 2 wherein the pneumatic impact strength is at least 4 kg-cm/0.0254 mm (1 mil).

4. The film of any one of Claims 1 to 3 wherein the inherent viscosity is at least 1.3 deciliters/g.

5. A method for treating an undrawn, non-crystalline film of a wholly aromatic polyamide, at least 85% of the repeating units of which are meta-phenylene isophthalamide units, to increase its pneumatic impact strength to at least 2 kg-cm/mil, said polyamide having an inherent viscosity of at least 1.2 deciliters/g in concentrated sulfuric acid at 30°C at a concentration of 0.5 gram of polymer per 100 cc of solution, said method comprising heating the film to a temperature in the range of 400 to 300°C for a period of time ranging from 2 seconds to 2 minutes, while maintaining the film at constant length and width or permitting the film to shrink by at most 20% in each of the length and width.

6. The method of Claim 5 wherein the film is maintained at constant length and is permitted to shrink by at most 20% at width.

7. The method of Claim 5 wherein the film is maintained at constant length and width.

8. The method of Claim 5, Claim 6 or Claim 7 wherein the pneumatic impact strength is increased to at least 4 kg-cm/0.0254 mm (1 mil).

9. The method of any one of Claims 5 to 8 wherein the heating is to a temperature in the range of 375 to 325°C for a period of time ranging from 2 to 30 seconds.

10. The method of any one of Claims 5 to 9 wherein the polyamide is poly-meta-phenylene isophthalamide.

11. A process for preparing a film of a wholly aromatic polyamide, at least 85% of the repeating units of which are meta-phenylene isophthalamide units, said polyamide having an inherent viscosity of at least 1.2 deciliters/g in concentrated sulfuric acid at 30°C at a concentration of 0.5 gram of polymer per 100 cc of solution, said process comprising

(1) casting onto a support a film of a solution which comprises
   (a) a liquid from the group consisting of N,N-dimethylformamide, N,N-dimethylacetamide, N-methyl-2-pyrrolidone and dimethylsulfoxide, said polyamide having a solubility at 20°C. of at least 0.5% by weight in said liquid,
   (b) from 0.2% to 15% by weight based on said liquid of a salt from the class consisting of calcium bromide, sodium bromide, ammonium bromide, lithium bromide, lithium chloride, calcium chloride, and magnesium chloride, said salt being characterized in that it forms a solution in said liquid which has a specific resistance of less than 5000 ohm-centimeters as measured on a solution of 1/100 of an equivalent of said salt in one liter of said liquid at 20°C,
   (c) from 3 to 30% by weight of said polyamide based on said liquid, and
   (d) up to 7% by weight of water based on the total weight of said liquid salt, polyamide and water;
(2) removing said liquid from said film by vaporizing it with heat at a temperature no greater than 5°C below the boiling point of said solution until the amount of said liquid in said film is in the range of 50 to 160% by weight based on said polyamide;
(3) washing additional said liquid from said film with water until the amount of said liquid in said film is less than 3% by weight and of said salt in said film is less than 0.3% by weight, each based on said polyamide.

(4) removing water remaining in said film from said film by vaporizing it with heat below a temperature of 150°C until the amount of water in said film is less than 15% by weight based on said polyamide while maintaining said film at constant length and width or permitting the film to shrink at most by about 12% in each of the length and width;

(5) removing said film from said support at a time during any of steps (2), (3) or (4); and

(6) heat treating said film at a temperature in the range of 400 to 300°C for a period of time ranging from 2 seconds to 2 minutes while maintaining the film at constant length and width or permitting the film to shrink by at most 20% in each of the length and width.

12. The process of Claim 11 wherein in step (6) the film is maintained at constant length and is permitted to shrink by at most 20% in width.

13. The process of Claim 11 wherein in step (6) the film is maintained at constant length and width.

14. The process of Claim 11 Claim 12 or Claim 13 wherein the polyamide is poly-meta-phenylene isophthalamide.

15. The process of any one of Claims 11 to 14 wherein the liquid is N,N-dimethylacetamide and the salt is $CaCl_2$.

16. The process of any one of Claims 11 to 15 wherein in step (6) the heat treating is at a temperature of 375 to 325°C for a time of 2 to 30 seconds.

17. The process of any one of Claims 11 to 16 wherein in step (3) said washing is until the amount of said liquid in said film is less than 2% by weight and of said salt in said film is less than 0.2% by weight, each based on said polyamide.

18. The process of claim 17 wherein in step (3) said washing is until the amount of said liquid in said film is less than 1% by weight and of said salt in said film is less than 0.1% by weight, each based on said polyamide.

19. The process of any one of Claims 11 to 18 wherein in step (4) water is removed until the amount remaining in said film is less than 8% by weight based on said polyamide.

**Patentansprüche**

1. Folie aus vollständig aromatischem Polyamid, wovon mindestens 85% der wiederkehrenden Einheiten meta-Phenylenisophthalamideinheiten sind, wobei das Polyamid eine Dichte von mindestens 1,32 $g/cm^3$, eine inhärente Viskosität von mindestens 1,2 Deziliter/g in Konzentrierter Schwefelsäure bei 30°C bei einer Konzentration von 0,5 g des Polymeren pro 100 $cm^3$ Lösung aufweist, und zu einem Ausmaß von 1 g Polyamid in einem Lösungsmittel bei 25°C löslich ist, das aus 9 g N,N-Dimethylacetamid und 1 g $CaCl_2 \cdot 2H_2O$ besteht, wobei diese Folie transparent, nicht verstreckt und nicht kristallin ist, und eine pneumatische Schlagzähigkeit von mindestens 2 kg-cm/0,0254 mm (1 mil) aufweist.

2. Folie nach Anspruch 1, in der das Polyamid Polymetaphenylenisophthalamid ist.

3. Folie nach Anspruch 1 oder 2, deren pneumatische Schlagzähigkeit mindestens 4 kg-cm/0,0254 mm (1 mil) beträgt.

4. Folie nach einem der Ansprüche 1 bis 3, deren inhärente Viskosität mindestens 1,3 Deciliter/g beträgt.

5. Verfahren zur Behandlung einer nicht verstreckten, nicht kristallinen Folie aus einem vollständig aromatischen Polyamid, wovon mindestens 85% der wiederkehrenden Einheiten meta-Phenylenisophthalamideinheiten sind, um ihre pneumatische Schlagzähigkeit auf mindestens 2 kg-cm/mil zu steigern, wobei das Polyamid eine inhärente Viskosität von mindestens 1,2 Deciliter/g in konzentrierter Schwefelsäure bei 30°C bei einer Konzentration von 0,5 g des Polymeren pro 100 $cm^3$ Lösung aufweist, wobei diese Methode darin besteht, die Folie auf eine Temperatur im Bereich von 400 bis 300°C während eines Zeitraums von 2 Sekunden bis 2 Minuten zu erwärmen, während die Folie in konstanter Länge und Breite gehalten wird oder die Folie um höchstens 20% jeweils in der Länge und der Breite schrumpfen kann.

6. Verfahren nach Anspruch 5, bei dem die Folie in konstanter Länge gehalten wird und um höchstens 20% in der Breite schrumpfen kann.

7. Verfahren nach Anspruch 5, bei dem die Folie auf konstanter Länge und Breite gehalten wird.

8. Verfahren nach Anspruch 5, Anspruch 6 oder Anspruch 7, bei dem die pneumatische Schlagzähigkeit auf mindestens 4 kg-cm/0,0254 mm (1 mil) gesteigert wird.

9. Verfahren nach einem der Ansprüche 5 bis 8, bei dem das Erwärmen auf eine Temperatur im Bereich von 375 bis 325°C während eines Zeitraums von etwa 2 bis 30 Sekunden durchgeführt wird.

10. Verfahren nach einem der Ansprüche 5 bis 9, bei dem das Polyamid Polymetaphenylenisophthalamid ist.

11. Verfahren zur Herstellung einer Folie aus vollständig aromatischem Polyamid, woven mindestens 85% der wiederkehrenden Einheiten meta-Phenylenisophthalamideinheiten sind, wobei das Polyamid eine inhärente Viskosität von mindestens 1,2 Deciliter/g in konzentrierter Schwefelsäure bei 30°C bei einer Konzentration von 0,5 g des Polymeren pro 100 cm³ Lösung aufweist, wobei dieses Verfahren umfaßt:

(1) Gießen einer Folie auf einen Träger aus einer Lösung, die enthält
   (a) eine Flüssigkeit aus der Gruppe von N,N-Dimethylformamid, N,N-Dimethylacetamid, N-Methyl-2-pyrrolidon und Dimethylsulfoxid, wobei das Polyamid eine Löslichkeit bei 20°C von mindestens 0,5 Gew.-% in der Flüssigkeit aufweist,
   (b) 0,2 bis 15 Gew.-%, basierend auf der Flüssigkeit von einem Salz aus der Klasse, bestehend aus Calciumbromid, Natriumbromid, Ammoniumbromid, Lithiumbromid, Lithiumchlorid, Calciumchlorid und Magnesiumchlorid, wobei das Salz dadurch charakterisiert ist, daß es eine Lösung in der Flüssigkeit bildet, die einen spezifischen Widerstand von weniger als 5000 Ohm-cm, gemessen an einer Lösung von 1/100 eines Äquivalents des Salzes in einem Liter der Flüssigkeit bei 20°C, aufweist,
   (c) 3 bis 30 Gew.-% des Polyamids, basierend auf der Flüssigkeit, und
   (d) bis zu 7 Gew.-% Wasser, basierend auf dem Gesamtgewicht von Flüssigkeit, Salz, Polyamid und Wasser;
(2) das Entfernen der Flüssigkeit von der Folie durch Verdampfen mit Wärme bei einer Temperatur von nicht größer als 5°C unter dem Siedepunkt der Lösung, bis die Menge der Flüssigkeit in der Folie im Bereich von 50 bis 160 Gew.-%, basierend auf dem Polyamid, beträgt;
(3) das zusätzliche Waschen der Flüssigkeit von der Folie mit Wasser, bis die Menge der Flüssigkeit in der Folie weniger als 3 Gew.-% und des Salzes in der Folie weniger als 0,3 Gew.-%, jeweils basierend auf dem Polyamid, beträgt;
(4) das Entfernen von in der Folie verbleibendem Wasser von der Folie durch Verdampfen mit Wärme unter einer Temperatur von 150°C, bis die Wassermenge in der Folie weniger als 15 Gew.-%, basierend auf dem Polyamid, beträgt, während die Folie auf konstanter Länge und Breite gehalten wird, oder die Folie zu höchstens etwa 12% jeweils in der Länge und der Breite schrumpfen kann;
(5) das Entfernen der Folie von dem Träger zu einem Zeitpunkt während jeglicher der Stufen (2), (3) oder (4); und
(6) die Wärmebehandlung der Folie bei einer Temperatur in Bereich von 400 bis 300°C während eines Zeitraums von 2 Sekunden bis 2 Minuten, wobei die Folie auf konstanter Länge und Breite gehalten wird, oder die Folie um höchstens 20% jeweils in der Länge und Breite schrumpfen kann.

12. Verfahren nach Anspruch 11, bei dem in der Stufe (6) die Folie auf konstanter Länge gehalten wird und um höchstens 20% in der Breite schrumpfen kann.

13. Verfahren nach Anspruch 11, bei dem in der Stufe (6) die Folie auf konstanter Länge und Breite gehalten wird.

14. Verfahren nach Anspruch 11, Anspruch 12 oder Anspruch 13, bei dem das Polyamid Polymetaphenylenisophthalamid ist.

15. Verfahren nach einem der Ansprüche 11 bis 14, bei dem die Flüssigkeit N,N-Dimethylacetamid und das Salz CaCl₂ ist.

16. Verfahren nach einem der Ansprüche 11 bis 15, bei dem in der Stufe (6) die Wärmebehandlung bei einer Temperatur von 375 bis 325°C während einer Zeit von 2 bis 30 Sekunden erfolgt.

17. Verfahren nach einem der Ansprüche 11 bis 16, bei dem in der Stufe (3) das Waschen erfolgt, bis die Menge der Flüssigkeit in der Folie weniger als 2 Gew.-% beträgt und das Salz in der Folie weniger als 0,2 Gew.-% beträgt, jeweils basierend auf dem Polyamid.

18. Verfahren nach Anspruch 17, bei dem in der Stufe (3) das Waschen erfolgt, bis die Menge der Flüssigkeit in der Folie weniger als 1 Gew.-% und des Salzes in der Folie weniger als 0,1 Gew.-% beträgt, jeweils basierend auf dem Polyamid.

19. Verfahren nach einem der Ansprüche 11 bis 18, bei dem in der Stufe (4) Wasser entfernt wird, bis die in der Folie verbleibende Menge weniger als 8 Gew.-%, basierend auf dem Polyamid, beträgt.

**Revendications**

1. Feuille d'un polyamide entièrement aromatique dont au moins 85% des unités récurrentes sont des unités méta-phénylène-isophtalamide, ce polyamide ayant une viscosité inhérente d'au moins 1,2 dl/g dans l'acide sulfurique concentré à 30°C à une concentration de 0,5 g de polymère par 100 cm³ de solution et étant soluble à raison de 1 g de polyamide dans un solvant formé de 9 g de N,N-diméthyl-acétamide et de 1 g de CaCl₂ · 2H₂O à 25°C, cette feuille étant transparente, non étirée et non cristalline et ayant une résistance au choc pneumatique d'au moins 2 kg-cm/0,0254 mm.

2. Feuille selon la revendication 1, dans laquelle le polyamide est du poly-méta-phénylène-isophtalamide.

3. Feuille selon la revendication 1 ou 2, dont la résistance au choc pneumatique est d'au moins 4 kg-cm/0,0254 mm.

4. Feuille selon l'une quelconque des revendications 1 à 3, dans laquelle la viscosité inhérente est d'au moins 1,3 dl/g.

5. Procédé de traitement d'une feuille non cristalline non étirée d'un polyamide entièrement aromatique dont au moins 85% des unités récurrentes sont des unités méta-phénylène-isophtalamide, en vue d'accroître sa résistance au choc pneumatique jusqu'à au moins 2 kg-cm/0,0254 mm, ce polyamide ayant une viscosité inhérente d'au moins 1,2 dl/g dans l'acide sulfurique concentré à 30°C à une concentration de 0,5 g de polymère par 100 cm$^3$ de solution, ce procédé consistant à chauffer la feuille à une température comprise entre 400 et 300°C pendant un laps de temps variant d'environ 2 secondes à 2 minutes, tout en maintenant la feuille à une longueur et à une largeur constantes ou en permettant à la feuille de se contracter de 20% au maximum sur sa longueur comme sur sa largeur.

6. Procédé selon la revendication 5, dans lequel on maintient la feuille à une longueur constante et on lui permet de se contracter au maximum de 20% en largeur.

7. Procédé selon la revendication 5, dans lequel on maintient la feuille à une longueur et à une largeur constantes.

8. Procédé selon l'une quelconque des revendications 5, 6 et 7, dans lequel la résistance au choc pneumatique est accrue jusqu'à au moins 4 kg-cm/0,0254 mm.

9. Procédé selon l'une quelconque des revendications 5 à 8, dans lequel le chauffage se fait à une température comprise entre 375 et 325°C pendant un laps de temps variant d'environ 2 à 30 secondes.

10. Procédé selon l'une quelconque des revendications 5 à 9, dans lequel le polyamide est du poly-méta-phénylène-isophtalamide.

11. Procédé de fabrication d'une feuille d'un polyamide entièrement aromatique dont au moins 85% des unités récurrentes sont des unités méta-phénylène-isophtalamide, ce polyamide ayant une viscosité inhérente d'au moins 1,2 dl/g dans l'acide sulfurique concentré à 30°C à une concentration de 0,5 g de polymère par 100 cm$^3$ de solution, ce procédé consistant:

(1) à couler sur un support une feuille d'une solution qui comprend:
   (a) un liquide choisi dans le groupe comprenant le N,N-diméthylformamide, le N,N-diméthyl-acétamide, la N-méthyl-2-pyrrolidone et le diméthylsulfoxyde, ce polyamide ayant une solubilité d'au moins 0,5% en poids dans ce liquide, à 20°C,
   (b) de 0,2 à 15% en poids, relativement au liquide, d'un sel de la classe comprenant le bromure de calcium, le bromure de sodium, le bromure d'ammonium, le bromure de lithium, le chlorure de lithium, le chlorure de calcium et le chlorure de magnésium, ce sel étant caractérisé en ce qu'il forme dans le liquide mentionné une solution qui a une résistance spécifique inférieure à 5000 ohm-cm, telle qu'on la mesure sur une solution de 1/100 d'un équivalent dudit sel dans un litre dudit liquide à 20°C,
   (c) de 3 à 30% en poids du polyamide relativement au liquide, et
   (d) jusqu'à 7% en poids d'eau, relativement au poids total de liquide, de sel, de polyamide et d'eau;
(2) à éliminer le liquide de la feuille en le vaporisant par chauffage à une température ne dépassant pas 5°C en dessous du point d'ébullition de la solution, jusqu'à ce que la quantité de liquide dans la feuille soit comprise entre 50 et 160% en poids, relativement au polyamide;
(3) à éliminer un supplément du liquide de la feuille par lavage à l'eau jusqu'à ce que la quantité du liquide dans la feuille soit inférieure à 3% en poids et que celle de sel dans la feuille soit inférieure à 0,3% en poids, chaque fois relativement au polyamide;
(4) à éliminer de la feuille l'eau qui reste dans la feuille en la vaporisant par chauffage en dessous d'une température de 150°C jusqu'à ce que la quantité d'eau dans la feuille soit inférieure à 15% en poids relativement au polyamide tout en maintenant la feuille à une longueur et à une largeur constante ou en permettant à la feuille de se contracter au maximum d'environ 12% en longueur comme en largeur;
(5) à retirer la feuille du support à un moment qui se situe au cours de l'une quelconque des étapes (2), (3) et (4); et
(6) à traiter thermiquement la feuille à une température comprise entre 400 et 300°C pendant un laps de temps variant de 2 secondes à 2 minutes tout en maintenant la feuille à une longueur et à une largeur constante ou en permettant à la feuille de se contracter au maximum de 20% en longueur comme en largeur.

12. Procédé selon la revendication 11, dans lequel, à l'étape (6), on maintient la feuille à une longueur constante et on lui permet de se contracter au maximum de 20% en largeur.

13. Procédé selon la revendication 11, dans lequel, à l'étape (6), on maintient la feuille à une longueur et à une largeur constantes.

14. Procédé selon la revendication 11, 12 ou 13, dans lequel le polyamide est du poly-méta-phénylène-isophtalamide.

15. Procédé selon l'une quelconque des revendications 11 à 14, dans lequel le liquide est du N,N-diméthylacétamide et le sel est CaCl$_2$.

16. Procédé selon l'une quelconque des revendications 11 à 15, dans lequel, à l'étape (6), le

11

traitement thermique est effectué à une température de 375 à 325°C pendant un temps de 2 à 30 secondes.

17. Procédé selon l'une quelconque des revendications 11 à 16, dans lequel, à l'étape (3), le lavage s'effectue jusqu'à ce que la quantité de liquide dans la feuille soit inférieure à 2% en poids et que celle de sel dans la feuille soit inférieure à 0,2% en poids, chaque fois relativement au polyamide.

18. Procédé selon la revendication 17, dans lequel, à l'étape (3), le lavage s'effectue jusqu'à ce que la quantité de liquide dans la feuille soit inférieure à 1% en poids et que celle de sel dans la feuille soit inférieure à 0,1% en poids, chaque fois relativement au polyamide.

19. Procédé selon l'une quelconque des revendications 11 à 18, dans lequel, à l'étape (4), on élimine de l'eau jusqu'à ce que la quantité restant dans la feuille soit inférieure à 8% en poids relativement au polyamide.